# EUROPEAN PATENT APPLICATION

(11) **EP 4 321 921 A1**
(43) Date of publication of application: **14.02.2024**
(21) Application number: 23742676.2
(22) Date of filing: 03.01.2023
(51) Int. Cl.: G02B 26/02

(54) **ELECTROWETTING SUBSTRATE, ELECTROWETTING DISPLAY PANEL AND ELECTROWETTING DISPLAY APPARATUS**

(30) Priority: 19.01.2022 CN 202210062793
(71) Applicant: Honor Device Co., Ltd., Shenzhen, Guangdong 518040 (CN)
(72) Inventor: CAI, Peizhi, Shenzhen, Guangdong 518040 (CN); QIAO, Yun, Shenzhen, Guangdong 518040 (CN)
(74) Representative: Maiwald GmbH
(86) International application number: PCT/CN2023/070201
(87) International publication number: WO 2023/138360

(57) **Abstract**

This application provides an electrowetting substrate, an electrowetting display panel, and an electrowetting display apparatus. In the electrowetting substrate, first scan lines and second scan lines are alternately arranged. Pixels are defined by data lines, the first scan lines, and the second scan lines. A first TFT connected to the first scan line as well as a second TFT and a third TFT that are connected to the second scan line are disposed in each pixel. A first metal layer, a second metal layer, and a reflective electrode layer are sequentially provided on a first base to form a first storage capacitor and a second storage capacitor. When the first scan lines are enabled, the first TFTs are turned on, and the second storage capacitor and the first storage capacitor are connected in series, so that overall capacitance is small, charging is fast, and fast refresh can be achieved. When the second scan lines are enabled, the second TFTs and the third TFTs jointly act, the second storage capacitor is short-circuited, and the first storage capacitor can provide long voltage holding time, so that a bistable state is achieved, and power consumption is reduced.

## Description

This application claims priority to Chinese Patent Application No. 202210062793.4, filed with the China National Intellectual Property Administration on January 19, 2022, and entitled "ELECTROWETTING SUBSTRATE, ELECTROWETTING DISPLAY PANEL, AND ELECTROWETTING DISPLAY APPARATUS", which is incorporated by reference herein in its entirety.

### TECHNICAL FIELD

This application relates to the field of display technologies, and in particular, to an electrowetting substrate, an electrowetting display panel, and an electrowetting display apparatus.

### BACKGROUND

For a reflective display screen, a reflective material is provided under the screen to replace a light-emitting material of a transmissive display. The reflective material is used for reflecting ambient light or light from an external light source to illuminate the screen. The reflective display screen has characteristics of eye protection and low power consumption.

Currently, reflective display screens on the market are mainly for monochrome display, are mainly used in fields such as electronic labels and e-books, and can only be used in limited display scenarios. The reflective display screens for monochrome display are mostly ink screens. Conventional ink screens are microcapsule ink screens. The microcapsule display screens consume extremely low power, but have low screen refresh rate, and therefore have difficulty being used for dynamic content display. Therefore, an electrowetting display screen has been developed. The electrowetting display screen controls "spreading-contracting" actions of a non-polar oil droplet on a hydrophobic dielectric layer via an electric field applied between two substrates, to achieve display. Compared with the microcapsule display screen, the electrowetting display screen has a higher refresh rate and a better dynamic content display effect.

However, the conventional electrowetting display screens are all monostable, and can maintain a contracted state of oil droplets only by continuously applying an electric field, resulting in high power consumption.

### SUMMARY

This application provides an electrowetting substrate, an electrowetting display panel, and an electrowetting display apparatus. The electrowetting substrate is characterized by both fast refresh and bistability, can be used in a wide range of scenarios, and consumes low power.

According to a first aspect, this application provides an electrowetting substrate, including a first base as well as a plurality of data lines, a plurality of first scan lines, a plurality of second scan lines, and a plurality of thin film transistors that are disposed on the first base.

The first scan lines and the second scan lines are alternately arranged and perpendicularly intersect the data lines. Pixels are defined by the data lines, the first scan lines, and the second scan lines. Each of the pixels is internally provided with the thin film transistors.

The electronic substrate further includes: a first metal layer, a first dielectric layer, a second metal layer, a second dielectric layer, and a reflective electrode layer that are sequentially disposed above the first base. The first metal layer, the first dielectric layer, and the second metal layer form a first storage capacitor, and the second metal layer, the second dielectric layer, and the reflective electrode layer form a second storage capacitor.

The thin film transistors include first thin film transistors, second thin film transistors, and third thin film transistors. The first thin film transistors are connected to the first scan lines. Both the second thin film transistors and the thin film transistors are connected to the second scan lines. When the first scan lines are enabled, and the second scan lines are disabled, the first storage capacitor and the second storage capacitor are connected in series. When the first scan lines are disabled, and the second scan lines are enabled, the first storage capacitor stores charge and the second storage capacitor is short-circuited.

In the electrowetting substrate according to this application, the first scan lines and the second scan lines are alternately arranged. Pixels are defined by the data lines, the first scan lines, and the second scan lines. Each of the pixels is internally provided with a first TFT, a second TFT, and a third TFT. The first TFTs are connected to the first scan lines, and both the second TFTs and the third TFTs are connected to the second scan lines. In addition, the first metal layer, the first dielectric layer, the second metal layer, the second dielectric layer, and the reflective electrode layer are sequentially disposed above the first base, so that a first storage capacitor is formed between the first metal layer and the second metal layer, and a second storage capacitor is formed between the second metal layer and the reflective electrode layer. When the first scan lines are enabled, and the second scan lines are disabled, the first TFTs are turned on to provide charge to the reflective electrode layer, so that the second storage capacitor and the first storage capacitor are connected in series. In this way, overall capacitance in the electrowetting substrate is small, charging is fast, and fast refresh can be achieved. When the first scan lines are disabled, and the second scan lines are enabled, the second TFTs and the third TFTs jointly act to provide charge to the second metal layer and the reflective electrode layer simultaneously, so that the second storage capacitor is short-circuited, only the first storage capacitor in the electrowetting substrate stores charge, and the first storage capacitor can provide long voltage holding time, thereby achieving a bistable state and reducing power consumption.

In a possible implementation, the first thin film transistors are connected between the data lines and the first scan lines, and are electrically connected to the reflective electrode layer.

When the first scan lines are enabled, and the second scan lines are disabled, the first TFTs are turned on to provide charge to the reflective electrode layer, the second storage capacitor is charged, and the charge is sequentially transmitted to the first storage capacitor, so that the second storage capacitor and the first storage capacitor are connected in series. In this way, overall capacitance in the electrowetting substrate is small, charging is fast, and fast refresh can be achieved.

In a possible implementation, the second thin film transistors are connected between the data lines and the second scan lines, and are electrically connected to the second metal layer.

The third thin film transistors are connected between the second metal layer and the second scan lines, and are electrically connected to the reflective electrode layer.

When the first scan lines are disabled, and the second scan lines are enabled, the second TFTs transmit an electrical signal to the second metal layer, the second metal layer transmits the electrical signal to the reflective electrode layer via the third TFTs, and the second metal layer is electrically connected to the reflective electrode layer, so that the second storage capacitor is short-circuited, only the first storage capacitor in the electrowetting substrate stores charge, and the first storage capacitor can provide long voltage holding time, thereby achieving a bistable state and reducing power consumption.

In a possible implementation, the reflective electrode layer covers the first thin film transistors, the second thin film transistors, and the third thin film transistors.

The reflective electrode layer covers the first TFTs, the second TFTs, and the third TFTs that are located below the reflective electrode layer and that are in the pixels, so that the opaque reflective electrode layer covers and protects the TFTs in the pixels, thereby reducing current leakage of the TFTs. In addition, a coverage area of the reflective electrode layer is increased, a reflective area of the pixels is increased, and a pixel aperture ratio is increased.

In a possible implementation, the reflective electrode layer covers an entire region of pixel openings of the pixels.

The reflective electrode layer covers an entire region of pixel openings of the pixels, so that the reflective area of the reflective electrode layer is maximized, and the pixel aperture ratio is maximized.

In a possible implementation, the data lines are disposed on a side that is of the first scan lines and the second scan lines and that is away from the first base. The second metal layer and the data lines are arranged in a same layer.

The second metal layer and the data lines are arranged in a same layer, to facilitate formation of the second metal layer. The second metal layer can be formed by using a same metal material as the data lines and through a same photolithography process. In addition, the data lines and the second metal layer are arranged in a same layer and above the first scan lines and the second scan lines, so that the second TFTs and the third TFTs formed can cause the second storage capacitor to be short-circuited.

In a possible implementation, the first scan lines, the second scan lines, and the first metal layer are arranged in a same layer.

The first metal layer, the first scan lines, and the second scan lines are arranged in a same layer, so that the first metal layer can be patterned and formed by using a same metal material as the first scan lines and the second scan lines through a same photolithography process. In addition, an overall thickness of the TFT substrate can be reduced, to facilitate design of a light and thin TFT substrate.

In a possible implementation, a third dielectric layer is further provided between the second metal layer and the second dielectric layer.

The thin third dielectric layer is provided between the second metal layer and the second dielectric layer. The third dielectric layer is mainly for protecting a channel structure of the TFTs from getting conductive in a subsequent metal layer formation process.

In a possible implementation, the first thin film transistor includes a first gate, a first source, a first drain, and a first active layer.

The first gate is connected to the first scan line. The first source is connected to the data line. The first drain and the first source are arranged in a same layer and spaced apart. The first drain is electrically connected to the reflective electrode layer. The first active layer is connected between the first source and the first drain. Orthographic projection of the first active layer on the first gate at least covers part of the first gate.

In a possible implementation, the second thin film transistor includes a second gate, a second source, and a second active layer.

The second gate is connected to the second scan line. The second source is connected to the data line. The second active layer is connected between the second source and the second metal layer. Orthographic projection of the second active layer on the second gate at least covers part of the second gate.

In a possible implementation, the second thin film transistor includes a second gate, a third gate, a second source, a second active layer, a third active layer, and a conductor layer.

The second gate and the third gate are spaced apart and connected to the second scan line. The second source is connected to the data line. The conductor layer is spaced apart from and disposed between the second source and the second metal layer. The second active layer is connected between the second source and the conductor layer. The third active layer is connected between the conductor layer and the second metal layer. Orthographic projection of the second active layer on the second gate at least covers part of the second gate. Orthographic projection of the third active layer on the third gate at least covers part of the third gate.

The second TFTs are each configured as a double-gate structure with two gates, that is, the second gate and the third gate. Correspondingly, the second TFTs each have two channel structures. When a current is transmitted in the second TFT, the current needs to pass the two channel structures. Because a channel structure has a large impedance, impedance formed by the two channel structures is greater, so that transmission speed of the current is reduced, and current leakage of the second TFTs can be reduced.

In a possible implementation, the third thin film transistor includes a fourth gate, a second drain, and a fourth active layer.

The fourth gate is connected to the second scan line. The second drain and the second metal layer are arranged in a same layer and spaced apart. The second drain is electrically connected to the reflective electrode layer. The fourth active layer is connected between the second metal layer and the second drain. Orthographic projection of the fourth active layer on the fourth gate at least covers part of the fourth gate.

According to a second aspect, this application provides an electrowetting display panel, including an opposing substrate, at least one electrowetting layer, and the foregoing electrowetting substrate.

The opposing substrate is cell-assembled with the electrowetting substrate. The electrowetting layer is encapsulated between the electrowetting substrate and the opposing substrate.

The electrowetting display panel according to this application includes a TFT substrate, the opposing substrate, and the electrowetting layer sandwiched between the TFT substrate and the opposing substrate. A wetting state of the electrowetting layer is controlled by an electric field generated between the TFT substrate and the opposing substrate, to enable the display panel to display a picture. In the TFT substrate, first scan lines and second scan lines are alternately arranged. Pixels are defined by data lines, the first scan lines, and the second scan lines. Each of the pixels is internally provided with a first TFT, a second TFT, and a third TFT. The first TFTs are connected to the first scan lines, and both the second TFTs and the third TFTs are connected to the second scan lines. In addition, a first metal layer, a second metal layer, and a reflective electrode layer are sequentially disposed above a first base, so that a first storage capacitor is formed between the first metal layer and the second metal layer, and a second storage capacitor is formed between the second metal layer and the reflective electrode layer. When the first scan lines are enabled, and the second scan lines are disabled, the first TFTs are turned on to provide charge to the reflective electrode layer, so that the second storage capacitor and the first storage capacitor are connected in series. In this way, overall capacitance in the electrowetting substrate is small, charging is fast, and fast refresh can be achieved. When the first scan lines are disabled, and the second scan lines are enabled, the second TFTs and the third TFTs jointly act to provide charge to the second metal layer and the reflective electrode layer simultaneously, so that the second storage capacitor is short-circuited, only the first storage capacitor in the electrowetting substrate stores charge, and the first storage capacitor can provide long voltage holding time, thereby achieving a bistable state and reducing power consumption.

In a possible implementation, the electrowetting layer includes a bottom electrowetting layer formed on a surface of the reflective electrode layer of the electrowetting substrate. The bottom electrowetting layer includes a transparent hydrophobic layer and a plurality of electrowetting units. The plurality of electrowetting units are arranged on the transparent hydrophobic layer in an array.

The electrowetting layer includes the bottom electrowetting layer. The bottom electrowetting layer is disposed on the reflective electrode layer of the TFT substrate. In the bottom electrowetting layer, a wetting state of the electrowetting units on the transparent hydrophobic layer of the bottom electrowetting layer is controlled by an electric field generated between the reflective electrode layer and the opposing substrate.

In a possible implementation, the electrowetting units are sandwiched between the transparent hydrophobic layer and the opposing substrate.

The electrowetting units between the reflective electrode layer and the opposing substrate may only include the bottom electrowetting layer. The electrowetting units of the bottom electrowetting layer are sandwiched between the transparent hydrophobic layer of the bottom electrowetting layer and a common electrode layer. A monochrome display effect is achieved via the bottom electrowetting layer. Alternatively, a color filter layer is provided in the opposing substrate, to achieve a color display effect by superposing the color filter layer and the bottom electrowetting layer.

In a possible implementation, the electrowetting layer further includes at least one superposed electrowetting layer stacked on a side that is of the bottom electrowetting layer and that is away from the reflective electrode layer.

The superposed electrowetting layer includes a transparent electrode layer, a transparent hydrophobic layer, and a plurality of electrowetting units. In the superposed electrowetting layer, the transparent hydrophobic layer is stacked on the transparent electrode layer, and the plurality of electrowetting units are arranged on the transparent hydrophobic layer in an array.

At least one superposed electrowetting layer is stacked on the bottom electrowetting layer. The color display effect is achieved through a superposition effect of the stacked superposed electrowetting layer and the bottom electrowetting layer. Each superposed electrowetting layer has an electrode layer to control the wetting state of the electrowetting units of the superposed electrowetting layer. In addition, an electrode layer of the superposed electrowetting layer is a transparent electrode layer, to facilitate transmission of light through the superposed electrowetting layer to irradiates the bottom electrowetting layer.

In a possible implementation, retaining walls are disposed between the transparent hydrophobic layer and the opposing substrate/the transparent electrode layer. The transparent hydrophobic layer, the retaining walls, and the opposing substrate/the transparent electrode layer define the electrowetting units. The electrowetting units are filled with polar liquid and non-polar liquid that are immiscible.

The electrowetting units corresponding to respective pixels are partitioned by the retaining walls. The electrowetting units are filled with polar liquid and non-polar liquid that are immiscible. A wetting state of the non-polar liquid in the electrowetting units of the bottom electrowetting layer is controlled via an electric field between the reflective electrode layer and the opposing substrate. Similarly, a wetting state of the non-polar liquid in the electrowetting units of the superposed electrowetting layer is controlled via an electric field between the transparent electrode layer of the superposed electrowetting layer and the opposing substrate.

In a possible implementation, the opposing substrate includes a second base and a common electrode layer. The common electrode layer is located on a side that is of the second base and that faces the electrowetting substrate.

According to a third aspect, this application provides an electrowetting display apparatus, including the foregoing electrowetting display panel.

The electrowetting display apparatus according to this application includes the electrowetting display panel. The electrowetting display panel includes a TFT substrate, the opposing substrate, and an electrowetting layer sandwiched between the TFT substrate and the opposing substrate. A wetting state of the electrowetting layer is controlled by an electric field generated between the TFT substrate and the opposing substrate, to enable the display panel to display a picture. In the TFT substrate, the first scan lines and the second scan lines are alternately arranged. Pixels are defined by the data lines, the first scan lines, and the second scan lines. Each of the pixels is internally provided with a first TFT, a second TFT, and a third TFT. The first TFTs are connected to the first scan lines, and both the second TFTs and the third TFTs are connected to the second scan lines. In addition, a first metal layer, a second metal layer, and a reflective electrode layer are sequentially disposed above a first base, so that a first storage capacitor is formed between the first metal layer and the second metal layer, and a second storage capacitor is formed between the second metal layer and the reflective electrode layer. When the first scan lines are enabled, and the second scan lines are disabled, the first TFTs are turned on to provide charge to the reflective electrode layer, so that the second storage capacitor and the first storage capacitor are connected in series. In this way, overall capacitance in the electrowetting substrate is small, charging is fast, and fast refresh can be achieved. When the first scan lines are disabled, and the second scan lines are enabled, the second TFTs and the third TFTs jointly act to provide charge to the second metal layer and the reflective electrode layer simultaneously, so that the second storage capacitor is short-circuited, only the first storage capacitor in the electrowetting substrate stores charge, and the first storage capacitor can provide long voltage holding time, thereby achieving a bistable state.

### BRIEF DESCRIPTION OF DRAWINGS

FIG. 1 is a schematic diagram of a structure of an electrowetting display apparatus according to an embodiment of this application;
FIG. 2 is a partial exploded view of FIG. 1;
FIG. 3 is a schematic diagram of a structure of a display panel according to an embodiment of this application;
FIG. 4 is a schematic diagram of a structure of a second display panel according to an embodiment of this application;
FIG. 5 is a schematic diagram of a structure of a third display panel according to an embodiment of this application;
FIG. 6 is a schematic diagram of a structure of a fourth display panel according to an embodiment of this application;
FIG. 7 is a top perspective view of a pixel of a TFT substrate of an electrowetting display panel according to related technologies;
FIG. 8 is a top perspective view of another pixel of a TFT substrate of an electrowetting display panel according to related technologies;
FIG. 9 is a top perspective view of a pixel of a TFT substrate according to an embodiment of this application;
FIG. 10 is a schematic diagram of a drive circuit of the pixel in FIG. 9;
FIG. 11 is a schematic cross-sectional view along A-A in FIG. 9;
FIG. 12 is a top perspective view of another pixel of a TFT substrate according to an embodiment of this application; and
FIG. 13 is a schematic diagram of a drive circuit of the pixel in FIG. 12.

### Descriptions of reference numerals:

1-display apparatus;
10-display panel; 11-housing; 11a-back cover; 11b-middle frame; 12-main board;
100-TFT substrate;
110-first base; 120-TFT driver layer 1201-via hole; 130-reflective electrode layer;
121, Data-data line 122a, Gate 1-first scan line; 122b, Gate2-second scan line; 123-first metal layer; 124-second metal layer; 125, T1-first TFT; 126, T2-second TFT; 127, T3-third TFT; 129-common voltage line
1251-first gate; 1252-first source; 1253-first drain; 1254-first active layer; 1261-second gate; 1262-second source; 1263-second active layer; 1264-third gate; 1265-third active layer; 1266-conductor layer; 1271-fourth gate; 1272-second drain; 1273-fourth active layer; 1281-first dielectric layer; 1282-second dielectric layer; 1283-third dielectric layer;
200-opposing substrate;
210-second base; 220-common electrode layer; 230-color filter layer;
231-red filter layer; 232-green filter layer; 233-blue filter layer; 234-black matrix;
300-electrowetting layer; 301-bottom electrowetting layer; 302-superposed electrowetting layer;
310-transparent hydrophobic layer 320-retaining wall; 330-electrowetting unit; 340-transparent electrode layer;
331-black oil droplet; 332-red oil droplet; 333-green oil droplet; 334-blue oil droplet;
C1-first storage capacitor; C2-second storage capacitor;
101-data line; 102-scan line; 103-TFT; 104-reflective electrode layer; 105-gate metal layer;
1031-gate; 1032-source; 1033-drain metal layer, drain; 1034-active layer;
1033a-via hole.

### DESCRIPTION OF EMBODIMENTS

Terms used in implementations of this application are merely intended to explain specific embodiments of this application rather than limit this application.

An electrowetting display technology is a reflective display technology that uses surface tension phenomenon of liquid and an external electric field to adjust surface tension of polar liquid in a pixel, so as to cause spreading and contracting of ink, thereby achieving optical switch and grayscale control. As a reflective display technology, the electrowetting display technology does not need a backlight source to provide backlight compared with a liquid crystal display (Liquid Crystal Display, LCD), and does not need to excite an organic light-emitting diode to emit light compared with an organic light-emitting diode (Organic Light-Emitting Diode, OLED) display. Therefore, the electrowetting display technology has an advantage of low power consumption.

In addition, an electrowetting display has light reflection efficiency of higher than 50%, and therefore, has a light intensity twice as high as that of the LCD and allows for viewing in a high light intensity condition. In addition, the electrowetting display does not need a polarizer or polarization, has no viewing angle range limitation, and has stable performance at all viewing angles.

In addition, compared with a conventional reflective microcapsule display screen, a movement speed of ink particles in a microcapsule of the microcapsule display screen is limited due to a blocking effect of filling liquid in the microcapsules, and the screen is low in refresh speed and is not applicable to dynamic content display. Because ink in the electrowetting display screen is agile in shape change, compared with the microcapsule display screen, the electrowetting display screen has a higher refresh rate and a better effect in displaying dynamic content such as a video and a GIF image.

Therefore, the electrowetting display technology is applied in more terminal devices, such as a mobile phone, a tablet computer, and an outdoor billboard. An embodiment provides an electrowetting display apparatus. The electrowetting display apparatus may be the foregoing terminal device. An example in which the electrowetting display apparatus is a mobile phone is used for description in the following. It may be understood that the electrowetting display apparatus may alternatively be the foregoing tablet computer, an outdoor billboard, or another terminal device. This is not limited in this embodiment.

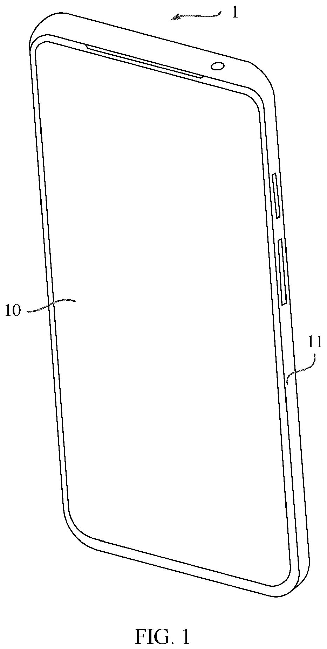

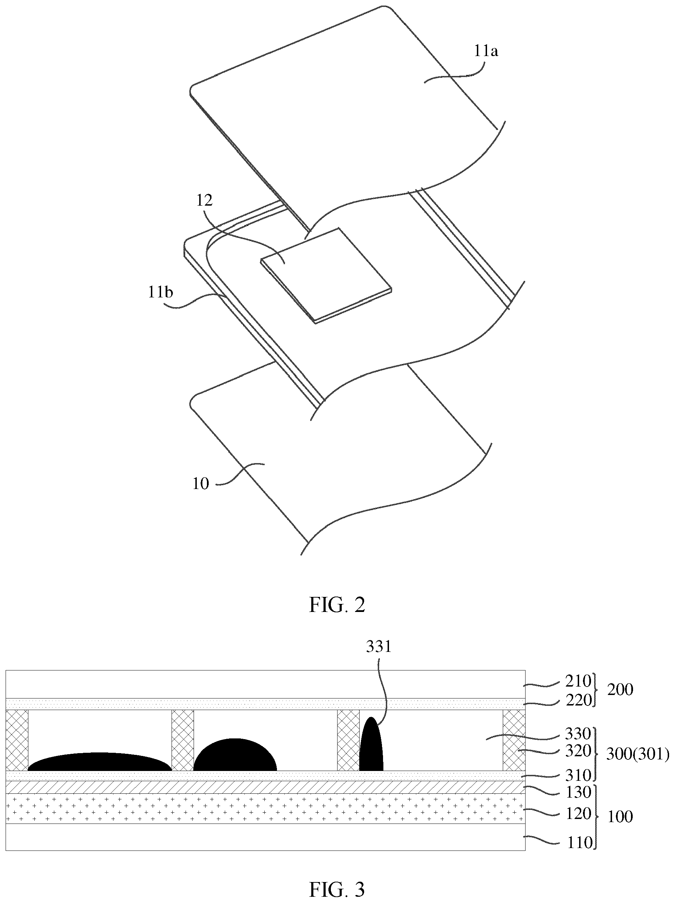

FIG. 1 is a schematic diagram of a structure of an electrowetting display apparatus according to an embodiment of this application. FIG. 2 is a partial exploded view of FIG. 1. Refer to FIG. 1 and FIG. 2. For example, in a mobile phone, an electrowetting display apparatus 1 may include an electrowetting display panel 10, a housing 11, and a main board 12. The housing 11 covers a back surface and side surfaces of the electrowetting display apparatus 1 (hereinafter referred to as a display apparatus for short). The electrowetting display panel 10 (hereinafter referred to as a display panel for short) is installed in a region surrounded by side walls of the housing 11. The display panel 10 is located on a front surface of the display apparatus 1. The display panel 10 and the housing 11 jointly define accommodating space of the display apparatus 1. The main board 12 is installed in the accommodating space. In addition, another component such as a loudspeaker and a battery may further be disposed in the accommodating space.

Refer to FIG. 2. The housing 11 may include a back cover 11a and a middle frame 11b. The back cover 11a is located on the back surface of the display apparatus 1. The middle frame 11b is connected between the display panel 10 and the back cover 11a. The main board 12 may be installed on the middle frame 11b. Exemplarily, the display panel 10 may be supported on the middle frame 11b. The main board 12 is installed on a side surface that is of the middle frame 11b and that is away from the display panel 10. The main board 12 may be electrically connected to the display panel 10. The main board 12 controls the display panel 10 to display a picture.

The following describes the display panel 10 in the display apparatus 1 in this embodiment in detail.

FIG. 3 is a schematic diagram of a structure of a display panel according to an embodiment of this application. Refer to FIG. 3. A display panel 10 includes two substrates and an electrowetting layer 300. A thin film transistor (Thin Film Transistor, TFT for short) array is disposed in one of the two substrates. The substrate may also be referred to as a TFT substrate 100. For convenience of description, the other substrate disposed on an opposite side of the TFT substrate 100 is referred to as an opposing substrate 200. The TFT substrate 100 is cell-assembled with the opposing substrate 200. The electrowetting layer 300 is encapsulated between the TFT substrate 100 and the opposing substrate 200. A transition state of the electrowetting layer 300 is controlled by an electric field generated between the TFT substrate 100 and the opposing substrate 200, to enable the display apparatus 1 to display a picture.

The TFT substrate 100 includes a first base 110, a TFT driver layer 120, and a reflective electrode layer 130. The first base 110 is, for example, a quartz base or a glass base. The TFT driver layer 120 is disposed on the first base 110. A TFT is formed in the TFT driver layer 120. The reflective electrode layer 130 is disposed on the TFT driver layer 120. A working state of the reflective electrode layer 130 is controlled by a switch state of TFTs in the TFT driver layer 120.

The opposing substrate 200 includes a second base 210 and a common electrode layer 220. Similar to the first base 110, the second base 210 may be a quartz base or a glass base. The common electrode layer 220 is disposed on the second base 210. When the TFT substrate 100 is cell-assembled with the opposing substrate 200, the reflective electrode layer 130 of the TFT substrate 100 is opposite to the common electrode layer 220 of the opposing substrate 200. The first base 110 and the second base 210 face away from each other. The electrowetting layer 300 is encapsulated between the reflective electrode layer 130 and the common electrode layer 220. A wetting state of the electrowetting layer 300 is controlled by using an electric field generated between the reflective electrode layer 130 and the common electrode layer 220 to achieve picture display.

The display panel 10 may include one or more electrowetting layers 300. The display panel 10 includes at least an electrowetting layer 300 directly formed on the reflective electrode layer 130 of the TFT substrate 100. The electrowetting layer 300 uses the reflective electrode layer 130 as a drive electrode of the electrowetting layer 300. For convenience of description, the electrowetting layer 300 directly formed on the reflective electrode layer 130 of the TFT substrate 100 is defined as a bottom electrowetting layer 301 in this embodiment.

Because the bottom electrowetting layer 301 is directly formed on the reflective electrode layer 130 of the TFT substrate 100 and is driven by the reflective electrode layer 130, the bottom electrowetting layer 301 may only include a transparent hydrophobic layer 310 and a plurality of electrowetting units 330 formed on the transparent hydrophobic layer 310. The electrowetting units 330 is arranged on the transparent hydrophobic layer 310 in an array. Each electrowetting unit 330 or a plurality of adjacent electrowetting units 330 corresponds to one pixel of the display panel 10. A wetting state of the electrowetting unit 330 on the transparent hydrophobic layer 310 is changed by changing a state of the electric field between the reflective electrode layer 130 of the TFT substrate 100 and the common electrode layer 220 of the opposing substrate 200, to change a display effect of the pixel.

Refer to FIG. 3. An example in which the display effect of the display panel 10 is monochrome display is used. The display panel 10 may only include an electrowetting layer 300. In other words, the display panel 10 may only include the bottom electrowetting layer 301. In this case, a bottom electrowetting layer 301 is sandwiched between the reflective electrode layer 130 of the TFT substrate 100 and the common electrode layer 220 of the opposing substrate 200. The electrowetting units 330 of the bottom electrowetting layer 301 are sandwiched between the transparent hydrophobic layer 310 of the bottom electrowetting layer 301 and the common electrode layer 220 of the opposing substrate 200. One electrowetting unit 330 may correspond to one pixel.

Retaining walls 320 are disposed between the transparent hydrophobic layer 310 of the bottom electrowetting layer 301 and the common electrode layer 220 of the opposing substrate 200. The retaining walls 320 are supported between the transparent hydrophobic layer 310 and the common electrode layer 220. The retaining walls 320 are disposed corresponding to boundaries between the pixels of the display panel 10. Exemplarily, the retaining walls 320 may be of a grid structure. The transparent hydrophobic layer 310 of the bottom electrowetting layer 301, the retaining walls 320, and the common electrode layer 220 of the opposing substrate 200 define the electrowetting units 330. The electrowetting units 330 respectively correspond to the pixels.

The electrowetting units 330 are filled with polar liquid (not shown) and non-polar liquid. The polar liquid and the non-polar liquid are in contact with each other and immiscible. Exemplarily, the polar liquid may be water or an aqueous solution, and the non-polar liquid may be an oil droplet. For the display panel 10 with a monochrome display effect, the non-polar liquid may be a black oil droplet 331.

Refer to a leftmost electrowetting unit 330 in FIG. 3. When no voltage is applied between the reflective electrode layer 130 of the TFT substrate 100 and the common electrode layer 220 of the opposing substrate 200, affinity of the black oil droplet 331 to the transparent hydrophobic layer 310 is greater than affinity of the polar liquid to the transparent hydrophobic layer 310. At this time, the black oil droplet 331 completely spreads on the transparent hydrophobic layer 310. When a voltage is applied between the reflective electrode layer 130 of the TFT substrate 100 and the common electrode layer 220 of the opposing substrate 200, charge distribution generated on the transparent hydrophobic layer 310 of the bottom electrowetting layer 301 increases the affinity of the transparent hydrophobic layer 310 to the polar liquid, so that the polar liquid squeezes the black oil droplet 331, and a contact angle between the black oil droplet 331 and the transparent hydrophobic layer 310 decreases. As the voltage between the reflective electrode layer 130 and the common electrode layer 220 gradually increases, the contact angle of the black oil droplet 331 and the transparent hydrophobic layer 310 gradually decreases. Refer to a middle electrowetting unit 330 in FIG. 3. The black oil droplet 331 contracts to a specific extent and occupies a specific region of the transparent hydrophobic layer 310. Refer to a rightmost electrowetting unit 330 in FIG. 3. When the voltage between the reflective electrode layer 130 and the common electrode layer 220 increases to a specific level, the black oil droplet 331 can completely contracts to a corner of the transparent hydrophobic layer 310.

In actual application, a side of the display panel 10 on which the TFT substrate 100 is located may face toward the inside of the display apparatus 1, and a side of the display panel 10 on which the opposing substrate 200 is located may face toward the outside of the display apparatus 1. In other words, external ambient light is incident from the opposing substrate 200, the common electrode layer 220 of the opposing substrate 200 has high transmittance, and the ambient light irradiates the TFT substrate 100 through the opposing substrate 200. The display panel 10 presents different display effects through light-shielding and light-transmitting functions of each electrowetting unit 330 in the TFT substrate 100.

Refer to the leftmost electrowetting unit 330 in FIG. 3. When the black oil droplet 331 spreads on the transparent hydrophobic layer 310, the black oil droplet 331 completely blocks a reflective metal layer below the black oil droplet 331, and the ambient light irradiates the TFT substrate 100. The pixel presents a black display effect through the light-shielding effect of the black oil droplet 331. Refer to the rightmost electrowetting unit 330 in FIG. 3. When the black oil droplet 331 contracts to the corner of the transparent hydrophobic layer 310, almost the entire region of the electrowetting unit 330 exposes the reflective electrode layer 130 below, and the ambient light irradiates the reflective electrode layer 130 through the transparent hydrophobic layer 310, and is reflected out from the display panel 10 by the reflective electrode layer 130, so that the pixel presents a white display effect. Refer to the middle electrowetting unit 330 in FIG. 3. When the black ink is in a state between two boundary states of fully spreading and contracting to the corner, the pixel presents a gray tone display effect through a joint action of the black oil droplet 331 and the reflective metal layer. A proportion of the transparent hydrophobic layer 310 blocked by the black oil droplets 331 is adjusted by regulating the voltage between the reflective electrode layer 130 and the common electrode layer 220, so that the pixels display grayscale effects of different shades.

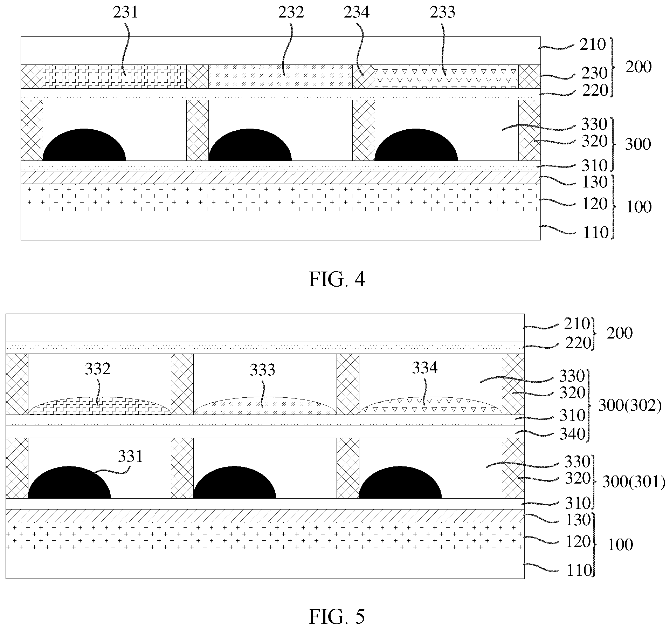

FIG. 4 is a schematic diagram of a structure of a second display panel according to an embodiment of this application. Refer to FIG. 4. Given that the electrowetting layer 300 of the display panel 10 only includes the bottom electrowetting layer 301 and non-polar liquid filled in the electrowetting unit 330 of the bottom electrowetting layer 301 is black oil droplets 331, to make the display panel 10 have a color display effect, as an implementation, a color filter layer 230 may be provided in the opposing substrate 200. After being incident on the display panel 10, external ambient light sequentially passes through the color filter layer 230 and the bottom electrowetting layer 301, and is reflected out of the display panel 10 through the TFT substrate 100, thereby achieving the color display effect of the display panel 10.

In the opposing substrate 200, the color filter layer 230 may be disposed between the second base 210 and the common electrode layer 220. A black matrix 234 may be disposed in the color filter layer 230. The black matrix 234 is similar to the retaining walls 320 in the bottom electrowetting layer 301. The black matrix 234 is supported between the common electrode layer 220 and the second base 210, and may be in a grid shape to divide the color filter layer 230 into filter units corresponding to respective sub-pixels. A light-shielding function of the black matrix 234 prevents light leakage between adjacent filter units.

Exemplarily, the color filter layer 230 may include red filter units 231, green filter units 232, and blue filter units 233. The red filter units 231, the green filter units 232, and the blue filter units 233 are sequentially arranged at intervals in regions defined by the black matrix 234 to form red sub-pixels, green sub-pixels, and blue sub-pixels; and a group of neighboring red sub-pixel, green sub-pixel, and blue sub-pixel constitute a pixel.

Refer to FIG. 4. The electrowetting units 330 correspond to the sub-pixels. In other words, an electrowetting unit 330 is provided below each filter unit. The example in which the neighboring red sub-pixel, green sub-pixel, and blue sub-pixel constitute a pixel is still used. Three neighboring electrowetting units 330 correspondingly disposed below a red filter unit 231, a green filter unit 232, and a blue filter unit 233 correspond to one pixel.

A proportion of the transparent hydrophobic layer 310 blocked by the black oil droplets 331 in the electrowetting units 330 below the filter units is adjusted by controlling a voltage between the reflective electrode layer 130 in each sub-pixel in the TFT substrate 100 and the common electrode layer 220 of the opposing substrate 200, so that the external ambient light irradiates each electrowetting unit 330 through each filter unit in the color filter layer 230, and the pixels present different colors through the light-shielding effect of the black oil droplets 331 and the light-reflecting effect of the reflective metal layer, to achieve the color display effect of the display panel 10.

In addition to by providing the color filter layer 230 on the opposing substrate 200 to achieve the color display effect, the color display effect may be achieved by stacking a plurality of electrowetting layers 300 between the TFT substrate 100 and the opposing substrate 200. Specifically, the electrowetting layer 300 between the TFT substrate 100 and the opposing substrate 200 may include the bottom electrowetting layer 301 and at least one superposed electrowetting layer 302 stacked on the bottom electrowetting layer 301.

As described above, the bottom electrowetting layer 301 includes the transparent hydrophobic layer 310 and the electrowetting units 330 that are sequentially stacked on the reflective electrode layer 130 of the TFT substrate 100. Similar to the bottom electrowetting layer 301, the superposed electrowetting layer 302 stacked on the bottom electrowetting layer 301 also includes a transparent hydrophobic layer 310 and an electrowetting unit 330. In addition, to control the electrowetting units 330 of the superposed electrowetting layer 302, the superposed electrowetting layer 302 also includes an electrode layer. In other words, the superposed electrowetting layer 302 includes the electrode layer, the transparent hydrophobic layer 310, and the electrowetting unit 330 that are sequentially stacked.

It should be noted that the display effect of the display panel 10 is achieved by each electrowetting layer 300 stacked between the TFT substrate 100 and the opposing substrate 200. Therefore, light incident onto the superposed electrowetting layer 302 can irradiate the bottom electrowetting layer 301 through the electrode layer of the superposed electrowetting layer 302. After ambient light sequentially passes through each electrowetting layer 300, the light formed is reflected out of the display panel 10 through the reflective electrode layer 130 of the TFT substrate 100. In this regard, the electrode layer of the superposed electrowetting layer 302 should be a transparent electrode layer 340, and the light irradiates the bottom electrowetting layer 301 through the transparent electrode layer 340 of the superposed electrowetting layer 302.

FIG. 5 is a schematic diagram of a structure of a third display panel according to an embodiment of this application. Refer to FIG. 5. As an implementation, the electrowetting layer 300 sandwiched between the TFT substrate 100 and the opposing substrate 200 includes the bottom electrowetting layer 301 and at one superposed electrowetting layer 302 stacked on the bottom electrowetting layer 301. Non-polar liquid filled in the electrowetting units 330 of the bottom electrowetting layer 301 is black oil droplets 331. Each electrowetting unit 330 in the superposed electrowetting layer 302 may be filled with non-polar liquid of different colors. For example, the non-polar liquid filled in each three neighboring electrowetting units 330 in the superposed electrowetting layer 302 are respectively a red oil droplet 332, a green oil droplet 333, and a blue oil droplet 334 to form a red sub-pixel, a green sub-pixel, and a blue sub-pixel. A group of neighboring red sub-pixel, green sub-pixel, and blue sub-pixel constitute a pixel.

A light shielding ratio of the black oil droplet 331 of the bottom electrowetting layer 301 in each sub-pixel is controlled by controlling a voltage between the reflective electrode layer 130 and the common electrode layer 220 corresponding to each sub-pixel, and further, a light transmission ratio of the color oil droplet in the superposed electrowetting layer 302 in each sub-pixel is controlled. For example, for the red sub-pixel, the light transmission ratio of the red oil droplets 332 located above the bottom electrowetting layer 301 is controlled by controlling the light shielding ratio of the black oil droplets 331 in the bottom electrowetting layer 301. Therefore, a color display effect is achieved by controlling the light transmission ratio of the red sub-pixel, the green sub-pixel, and the blue sub-pixel in each pixel.

There may be no voltage applied between the transparent electrode layer 340 of the superposed electrowetting layer 302 and the common electrode layer 220. In other words, the transparent electrode layer 340 of the superposed electrowetting layer 302 is not energized. In this way, the color oil droplets in the electrowetting units 330 of the superposed electrowetting layer 302 spread on the transparent hydrophobic layer 310, and the light transmission ratio of each sub-pixel is controlled only by controlling the light shielding ratio of the black oil droplet 331 in the bottom electrowetting layer 301. Alternatively, a voltage may be applied between the transparent electrode layer 340 of the superposed electrowetting layer 302 and the common electrode layer 220. A contraction ratio of the color oil droplet may be controlled by controlling the voltage between the transparent electrode layer 340 of the superposed electrowetting layer 302 and the common electrode layer 220 in each sub-pixel. In this way, the color display effect is achieved through a superposed light transmission effect of the color oil droplets and the black oil droplets 331.

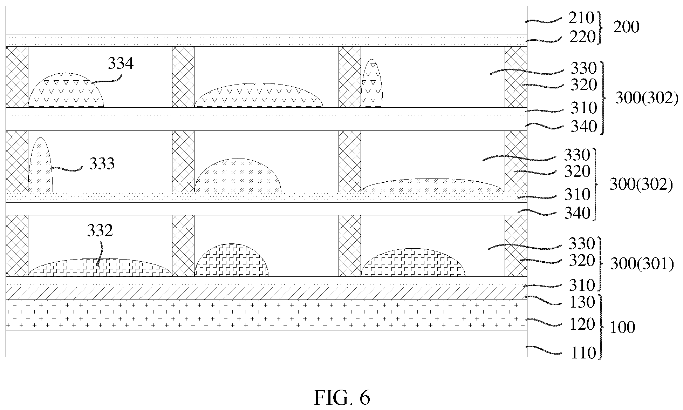

As another implementation, the electrowetting units 330 with different colors may alternatively be stacked in a thickness direction of the display panel 10 to achieve the color display effect through superposition of the color oil droplets of different colors. FIG. 6 is a schematic diagram of a structure of a fourth display panel according to an embodiment of this application. Refer to FIG. 6. Two superposed electrowetting layers 302 may be sequentially stacked above the bottom electrowetting layer 301. Color oil droplets in the electrowetting units 330 of three electrowetting layers 300 have different colors. The ambient light sequentially passes through the three electrowetting layer 300, and then is reflected out of the display panel 10 through the reflective electrode layer 130 to achieve the color display effect.

Exemplarily, red oil droplets 332 may be provided in the electrowetting units 330 of the bottom electrowetting layer 301, and green oil droplets 333 and blue oil droplets 334 may be provided in the electrowetting units 330 of two superposed electrowetting layers 302 above the bottom electrowetting layer 301. A coverage ratio of the red oil droplets 332 on the transparent hydrophobic layer 310 is controlled by a voltage between the reflective electrode layer 130 below the bottom electrowetting layer 301 and the common electrode layer 220 of the opposing substrate 200. Coverage ratios of the green oil droplets 333 and the blue oil droplets 334 on the corresponding transparent hydrophobic layers 310 are respectively controlled by voltages between the transparent electrode layers 340 of the two superposed electrowetting layers 302 and the common electrode layer 220. External ambient light sequentially passes through the electrowetting units 330 of each electrowetting layer 300, and red light, green light, and blue light are superposed and combined to achieve the color display effect.

In addition, in an indoor lighting environment during a day or a night, intensity of the external ambient light is sufficient. Therefore, the display panel 10 can display a picture simply by using the external ambient light reflected by the reflective electrode layer 130. However, in a dark night or in an environment with insufficient indoor lighting, the intensity of external ambient light is insufficient and there is no sufficient light to illuminate the display panel 10. In this case, a supplementary light source may alternatively be provided on a light incident side of the electrowetting layer 300. For example, the supplementary light source may be provided in the opposing substrate 200. When the external ambient light is insufficient, the light emitted by the supplementary light source can be introduced to illuminate the display panel 10.

The following describes the TFT substrate 100 in the display panel 10 in this embodiment in detail.

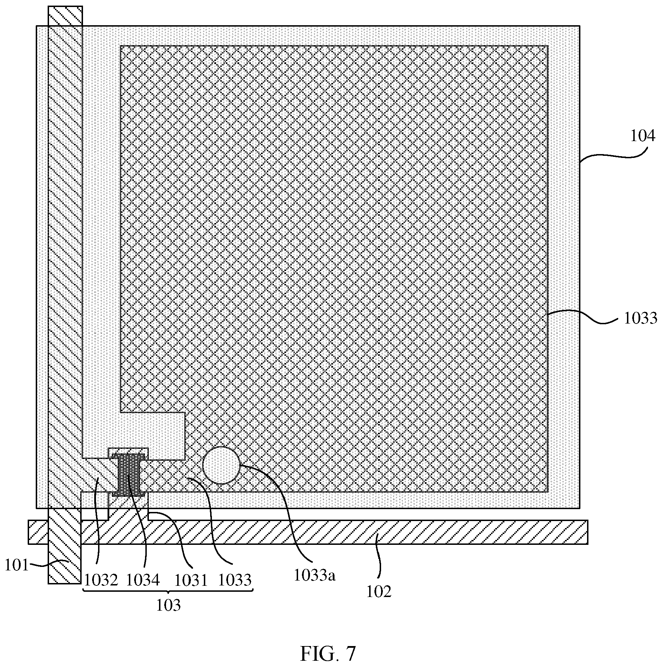

FIG. 7 is a top perspective view of a pixel of a TFT substrate of an electrowetting display panel in related technologies. Refer to FIG. 7. To facilitate presentation of a structure of the TFT substrate, only a structure of one pixel is shown in FIG. 7. Similarly, accompanying drawings appearing after this embodiment all describe a structure of one pixel of a TFT substrate.

Refer to FIG. 7. In related technologies, in a TFT substrate of an electrowetting display panel, a TFT 103 is provided in a pixel defined by a data line 101 and a scan line 102. The TFT 103 includes a gate 1031 connected to the scan line 102, a source 1032 connected to the data line 101, a drain 1033 spaced apart from the source 1032, and an active layer 1034 connected between the source 1032 and the drain 1033. The drain is connected to a reflective electrode layer 104 located on a top layer of the TFT substrate through a via hole 1033a. When the TFT 103 is turned on, an electrical signal is transmitted to the reflective electrode layer 104 via the drain 1033, so that a voltage signal is generated between a reflective electrode layer 104 and a common electrode layer of an opposing substrate.

The drain 1033 may be formed by a metal layer arranged in a same layer as the scan line 102. In this embodiment, the drain is defined as a drain metal layer 1033. Because a thick dielectric layer is sandwiched between the drain metal layer 1033 and the reflective electrode layer 104 (not shown), a spacing between the two layers is large, and the capacitance of a storage capacitor formed is very small. Therefore, only when the TFT 103 is remained in an ON state to continuously transmit electrical signals to the reflective electrode layer 104, the electric field can be generated between the reflective electrode layer 104 and the common electrode layer of the opposing substrate, so that an oil droplet in the electrowetting unit 330 can be remained in a contracted state. If the TFT 103 is turned off, the oil droplet returns to a spreading state.

Because such TFT substrate uses a monostable design, the contracted state of the oil droplet can be remained only by continuously energizing the reflective electrode layer 104 through the TFT 103. In this way, the display panel can be refreshed quickly, but power consumption is high.

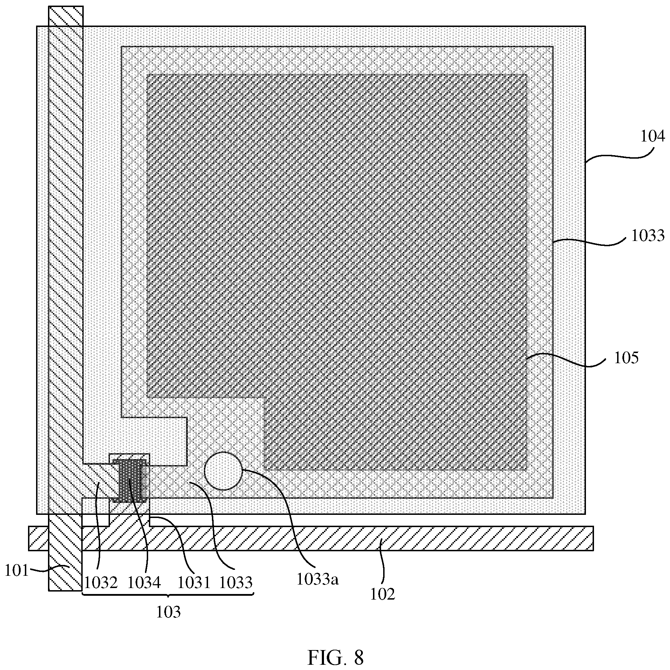

FIG. 8 is a top perspective view of another pixel of a TFT substrate of an electrowetting display panel in related technologies. Refer to FIG. 8. To achieve a bistable effect of the display panel, that is, after the TFT 103 is turned off, an oil droplet may remain in a contracted state without spreading. In related technologies, the bistable design can be implemented by adding a storage capacitor with a larger capacitance in the pixel. In this way, after the TFT 103 is turned off, the voltage between the reflective electrode layer 104 and the common electrode layer may be remained through the storage capacitor, so that the oil droplet remains in a contracted state.

A metal layer formed in the layer where the scan line 102 is located is defined as a gate metal layer 105 in this embodiment. There is no connection between the gate metal layer 105 and the gate 1031. The dielectric layer sandwiched between the gate metal layer 105 and the drain metal layer 1033 is very thin, a spacing between the two layers is small, and the capacitance of a storage capacitor formed is very large.

However, because a storage capacitor with a large capacitance is formed in such TFT substrate and impedance of the storage capacitor is large, a current transmission rate is affected, and therefore a refresh speed of the display panel is affected.

In this regard, in the TFT substrate 100 of this embodiment, based on the design of a pixel structure, the TFT substrate 100 has fast refresh and bistability performance, can be used in different application scenarios, and can reduce power consumption.

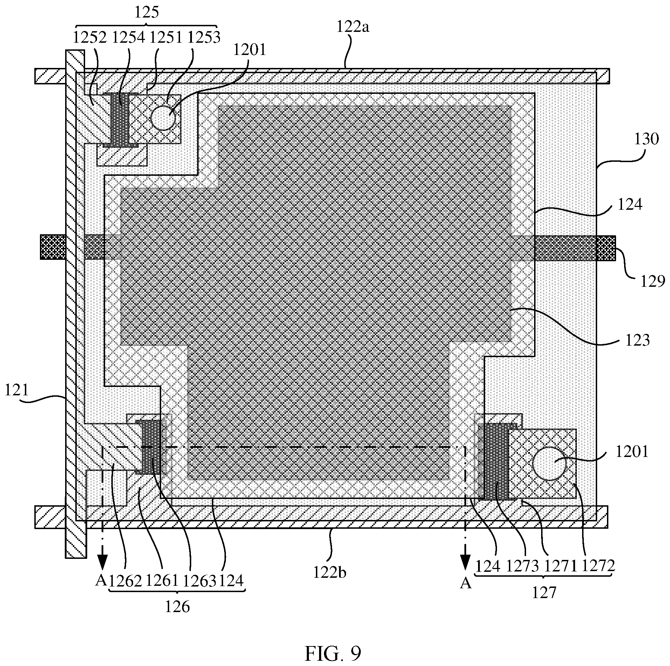

FIG. 9 is a top perspective view of a pixel of a TFT substrate according to an embodiment of this application. In FIG. 9, the first base 110 is not shown, and main layers in the TFT driver layer 120 and a structure of the reflective electrode layer 130 formed on the first base 110 are shown. Refer to FIG. 9. A plurality of data lines 121 and a plurality of scan lines are disposed on the first base 110. The data lines 121 are arranged parallel to each other at intervals, the plurality of scan lines are arranged parallel to each other at intervals, and the data lines 121 and the scan lines perpendicularly intersect each other in space. An example in which a shape of the TFT substrate 100 is a rectangle is used. Exemplarily, the data lines 121 may extend along a width direction of the TFT substrate 100, and the scan lines may extend along a length direction of the TFT substrate 100. Alternatively, the data lines 121 may extend along the length direction of the TFT substrate 100, and the scan lines may extend along the width direction of the TFT substrate 100. The data lines 121 and the scan lines divide the TFT substrate 100 into a plurality of pixels arranged in a matrix.

Each of the pixels is internally provided with TFTs, and a display state of each pixel is controlled by the TFTs. In actual application, a driver power supply is usually disposed in the TFT substrate 100. For example, the driver power supply may be disposed on an edge of one or two sides of the TFT substrate 100. The driver power supply is connected to the data lines 121 and scan lines near the edges of the TFT substrate 100, to drive all the data lines 121 and scan lines in a pixel region, then drive the TFTs in the pixels via the data lines 121 and the scan lines, and further drive the display panel 10 to display a picture via the TFTs. Exemplarily, the data lines 121 and the scan lines may drive the TFTs in a progressive scanning manner.

Still refer to FIG. 9. In this embodiment, the scan lines include first scan lines 122a and second scan lines 122b disposed alternately. Each pixel is defined by data lines 121 on two sides and a first scan line 122a and a second scan line 122b disposed oppositely. The pixel is controlled by the data line 121 on one side as well as the first scan line 122a and the second scan line 122b. In actual application, scan lines may be arranged at intervals in groups. Each group of scan lines includes the first scan line 122a and second scan line 122b that are adjacent. The first scan line 122a corresponds to a pixel, and the second scan line 122b corresponds to another adjacent pixel.

In addition, each pixel is internally provided with three TFTs, which are a first TFT 125, a second TFT 126, and a third TFT 127, respectively. The first TFT 125 is connected to the first scan line 122a, and both the second TFT 126 and the third TFT 127 are connected to the second scan line 122b. When the first scan line 122a is enabled, and the second scan line 122b is disabled, the first TFT 125 is turned on, the second TFT 126 and the third TFT 127 are turned off, and the first TFT 125 provides an electrical signal to the reflective electrode layer 130. When the first scan line 122a is disabled, and the second scan line 122b is enabled, the first TFT 125 is turned on, the second TFT 126 and the third TFT 127 are turned off, and the second TFT 126 and the third TFT 127 provide an electrical signal to the reflective electrode layer 130.

Still refer to FIG. 9. A first metal layer 123 and a second metal layer 124 are further disposed in the TFT driver layer 120. The first metal layer 123 and the second metal layer 124 are sequentially disposed above the first base 110. A first storage capacitor C1 may be formed between the first metal layer 123 and the second metal layer 124, and a second storage capacitor C2 may be formed between the second metal layer 124 and the reflective electrode layer 130 located above second metal layer 124. A spacing between the first metal layer 123 and the second metal layer 124 is small, and the first storage capacitor C1 formed between the two layers has a large capacitance. A spacing between the second metal layer 124 and reflective electrode layer 130 is small, and the second storage capacitor C2 formed between the two layers has a small capacitance.

The first TFT 125 is connected between the data line 121 and the first scan line 122a, and the first TFT 125 is electrically connected to the reflective electrode layer 130 through the via hole 1201. The second TFT 126 is connected between the data line 121 and the second scan line 122b, and the second TFT 126 is electrically connected to the second metal layer 124. The third TFT 127 is connected between the second metal layer 124 and the second scan line 122b, and the third TFT 127 is electrically connected to the reflective electrode layer 130 through the via hole 1201.

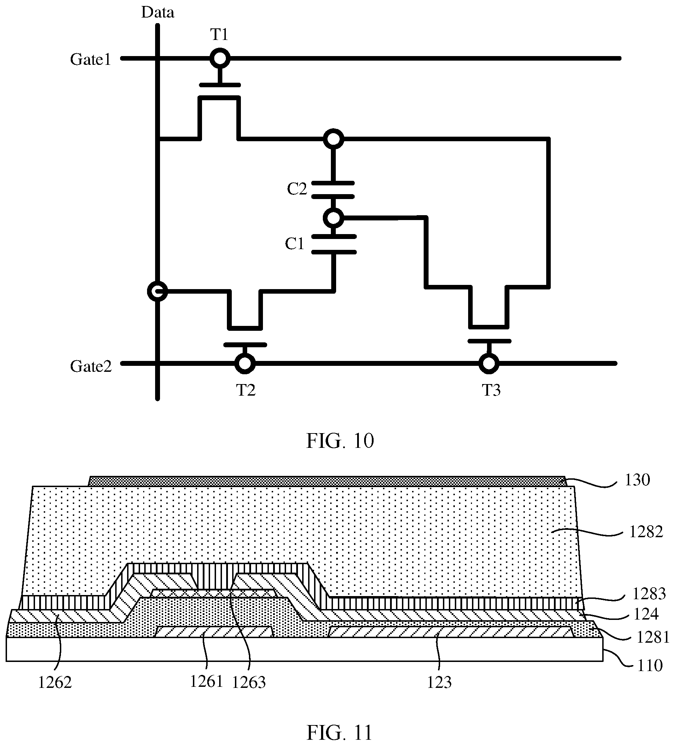

FIG. 10 is a schematic diagram of a drive circuit of the pixel in FIG. 9. To simplify labeling, the first TFT, the second TFT, and the third TFT are respectively labeled as T1, T2, and T3 in FIG. 10. Refer to FIG. 9 and FIG. 10. When the first scan line 122a is enabled, and the second scan line 122b is disabled, the first TFT 125 (T1) is turned on, the second TFT 126 (T2) and the third TFT 127 (T3) are turned off, and the first TFT 125 (T1) provides an electrical signal to the reflective electrode layer 130. The second storage capacitor C2 formed between the reflective electrode layer 130 and the second metal layer 124 is charged. After the second metal layer 124 generates charge, the first storage capacitor C1 between the second metal layer 124 and the first metal layer 123 is charged. In this case, the second storage capacitor C2 and the first storage capacitor C1 are connected in series. Because the capacitance of the second storage capacitor C2 is very small, after the second storage capacitor C2 and the first storage capacitor C1 are connected in series, overall capacitance of the two capacitors is smaller. Therefore, charging is fast, without affecting a refresh speed of the display panel 10.

When the first scan line 122a is disabled, and the second scan line 122b is enabled, the first TFT 125 (T1) is turned off, the second TFT 126 (T2) is turned on, and the second TFT 126 (T2) transmits an electrical signal to the second metal layer 124. The third TFT 127 (T3) is enabled, and the third TFT 127 provides an electrical signal to the reflective electrode layer 130. After the third TFT 127 (T3) is turned on, the second TFT 126 (T2) and the third TFT 127 (T3) that act jointly simultaneously provide an electrical signal to the second metal layer 124 and the reflective electrode layer 130. This equivalent to that two electrode plates of the second storage capacitor C2 are electrically connected, the second storage capacitor C2 is short-circuited, and only the first storage capacitor C1 exists in the TFT substrate 100. Because the capacitance of the first storage capacitor C1 is large enough, after the first storage capacitor C1 is fully charged, longer voltage holding time can be held, thereby achieving a bistable effect.

In actual application, in a scenario such as watching a video, the display panel 10 needs to be in a high-speed refresh state. In this case, the first scan lines 122a may be enabled, and the second scan lines 122b may be disabled. Overall capacitance of the storage capacitor in the TFT substrate 100 is very small, so that charging is fast, without affecting refresh time of the display panel 10. In a scenario such as reading text, a single picture is remained for a long time without a need for high-speed refresh of the display panel 10. In this case, the first scan lines 122a may be disabled, and the second scan lines 122b may be enabled. The first storage capacitor C1 with a large capacitance provides longer voltage holding time for the reflective electrode layer 130, to achieve a bistable state and reduce power consumption of the display panel 10.

In this embodiment, the reflective electrode layer 130 serves as a drive electrode, and a wetting state of the oil droplets in the electrowetting units 330 is controlled via an electric field generated between the reflective electrode layer 130 and the common electrode layer 220 of the opposing substrate 200. Provided that the reflective electrode layer 130 between adjacent pixels is spaced apart, the reflective electrode layer 130 may cover opening regions of the pixels as much as possible. Peripheral edges of the reflective electrode layer 130 may extend to cover the TFTs located below the reflective electrode layer 130 in the pixels. In other words, the reflective electrode layer 130 covers the first TFTs 125, the second TFTs 126, and the third TFTs 127.

In this way, the opaque reflective electrode layer 130 may cover each TFT located below the reflective electrode layer 130 in the pixel to protect each TFT from impact of the external ambient light or a supplementary light source, thereby reducing current leakage of the TFTs, improving performance of the TFTs, and reducing the power consumption of the TFTs. Furthermore, the reflective electrode layer 130 located on a top layer of the TFT substrate 100 is not affected by the TFTs below the reflective electrode layer 130, thereby increasing the coverage area of the reflective electrode layer 130, increasing the reflective area of the pixels, and increasing the pixel aperture ratio. The pixel openings of the pixels refer to regions surrounded by the data lines 121, the first scan lines 122a, and the second scan lines 122b.

Exemplarily, the peripheral edges of the reflective electrode layer 130 may correspondingly extend into the coverage region of the data lines 121, the first scan lines 122a and the second scan lines 122b surrounding the pixel. In this way, the reflective electrode layer 130 may cover an entire region of pixel openings of the pixels, so that the reflective area of the reflective electrode layer 130 is maximized, and the pixel aperture ratio is maximized.

FIG. 11 is a schematic cross-sectional view along A-A in FIG. 9. Refer to FIG. 9 and FIG. 11. In actual application, the data lines 121 may be disposed above the first scan lines 122a and the second scan lines 122b. In other words, each TFT in the pixel may be a bottom gate structure. In addition, the second metal layer 124 and the data lines 121 are arranged in a same layer. In this way, the second metal layer 124 can be formed by using a same metal material as the data lines 121 and through a same photolithography process.

In addition, the data line 121 is disposed above the first scan line 122a and the second scan line 122b. When the first scan line 122a is disabled, and the second scan line 122b is enabled, the second TFT 126 and the third TFT 127 are turned on, so that the second metal layer 124 and the reflective electrode layer 130 arranged in the same layer as the data lines 121 are electrically connected, to cause the second storage capacitor C2 to be short-circuited.

In addition, the first scan line 122a and the first scan line 122a may be arranged in a same layer, and the first metal layer 123, the first scan line 122a, and the second scan lines 122b are arranged in a same layer. In this way, the first metal layer 123 can be patterned and formed by using a same metal material as the first scan lines 122a and the second scan lines 122b through a same photolithography process. In addition, the first scan lines 122a, the second scan lines 122b, and the first metal layer 123 are arranged in the same layer, so that an overall thickness of the TFT substrate 100 can be reduced, thereby facilitating design of a light and thin TFT substrate 100.

In some other embodiments, the first scan lines 122a and the second scan lines 122b may be alternatively stacked in a thickness direction of the TFT substrate 100. For example, the second scan lines 122b are located above the first scan lines 122a, and an insulating layer is disposed between the second scan lines 122b and the first scan lines 122a to insulate and isolate the first scan lines 122a and the second scan lines 122b. The first metal layer 123 may be arranged in a same layer as the first scan lines 122a or the second scan lines 122b.

Refer to FIG. 11. A first dielectric layer 1281 is disposed between the first metal layer 123 and the second metal layer 124. The first dielectric layer 1281 is an insulating layer formed of an insulating material. For example, the first dielectric layer 1281 is a silicon oxide layer or a silicon nitride layer. The first storage capacitor C1 are formed by the first metal layer 123, the first dielectric layer 1281, and the second metal layer 124 together. A thickness of the first dielectric layer 1281 is small, a spacing between the first metal layer 123 and the second metal layer 124 is small, and therefore the capacitance of the first storage capacitor C1 is large.

A second dielectric layer 1282 is disposed between the second metal layer 124 and the reflective electrode layer 130. The second dielectric layer 1282 is an insulating layer formed of an insulating material. For example, the second dielectric layer 1282 is a silicon oxide layer or a silicon nitride layer. The second storage capacitor C2 are formed by the second metal layer 124, the second dielectric layer 1282, and the reflective electrode layer 130 together. A thickness of the second dielectric layer 1282 is large, a spacing between the second metal layer 124 and reflective electrode layer 130 is large, and therefore the capacitance of the second storage capacitor C2 is small.

In addition, a thin third dielectric layer 1283 may be disposed between the second metal layer 124 and the thick second dielectric layer 1282. The third dielectric layer 1283 may also be an insulating layer formed of an insulating material. The third dielectric layer 1283 is mainly for protecting performance of each TFT, to prevent affecting semiconductor performance of channel structures of the TFTs in a subsequent metal layer (for example, the reflective electrode layer 130) formation process. Exemplarily, the third dielectric layer 1283 may be a silicon oxide layer, and the second dielectric layer 1282 may be a silicon nitride layer. The silicon oxide layer is mainly for protecting the channel structures of the TFTs from getting conductive in the subsequent metal layer formation process. For example, the silicon nitride layer may prevent entry of external water vapor into the TFT substrate 100.

Refer to FIG. 9. The first TFT 125 connected between the data line 121 and the first scan line 122a includes a first gate 1251, a first source 1252, a first drain 1253, and a first active layer 1254. The first gate 1251 is connected to the first scan line 122a. The first source 1252 is connected to the data line 121. The first drain 1253 and the first source 1252 are arranged in a same layer and spaced apart. The first drain 1253 is connected to the reflective electrode layer 130 through the via hole 1201. The first active layer 1254 is connected between the first source 1252 and the first drain 1253. Orthographic projection of the first active layer 1254 on the first gate 1251 at least covers part of the first gate 1251. Exemplarily, the orthographic projection of the first active layer 1254 on the first gate 1251 may be located within the first gate 1251. A channel structure of the first TFT 125 refers to a stacked structure between the first source 1252, the first active layer 1254, and the first drain 1253.

Refer to FIG. 9 and FIG. 11. The second TFT 126 connected between the data line 121 and the second metal layer 124 includes a second gate 1261, a second source 1262, and a second active layer 1263. The second gate 1261 is connected to the second scan line 122b. The second source 1262 is connected to the data line 121. The second active layer 1263 is connected between the second source 1262 and the metal layer 124. Orthographic projection of the second active layer 1263 on the second gate 1261 at least covers part of the second gate 1261. Exemplarily, the orthographic projection of the second active layer 1263 on the second gate 1261 may be located within the second gate 1261. A channel structure of the second TFT 126 refers to a stacked structure between the second source 1262, the second active layer 1263, and the second metal layer 124.

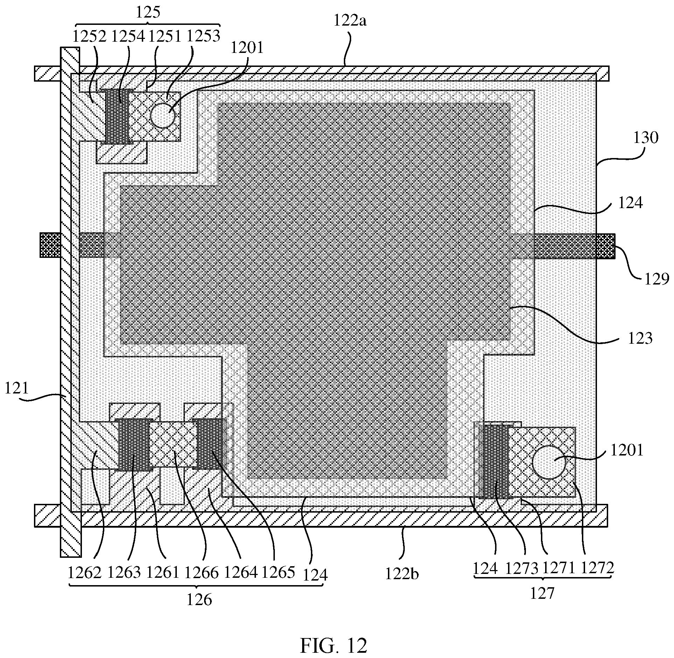

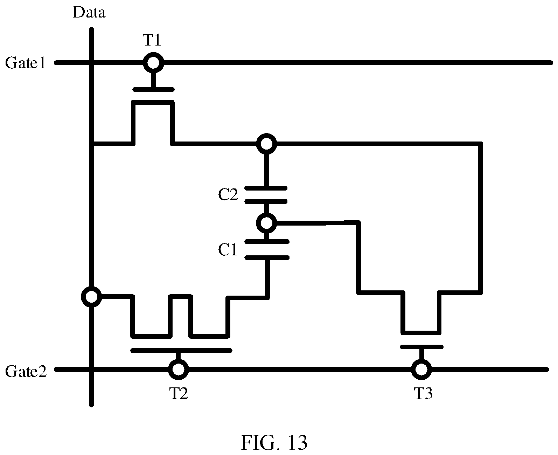

FIG. 12 is a top perspective view of another pixel of a TFT substrate according to an embodiment of this application. FIG. 13 is a schematic diagram of a drive circuit of the pixel in FIG. 12. Similar to FIG. 10, to simplify labeling, the first TFT, the second TFT, and the third TFT are respectively labeled as T1, T2, and T3 in FIG. 13. Refer to FIG. 12. Different from the pixel shown in FIG. 9, the second TFT 126 connected between the data line 121 and the second metal layer 124 includes a second gate 1261, a third gate 1264, a second source 1262, a second active layer 1263, a third active layer 1265, and a conductor layer 1266. The second gate 1261 and the third gate 1264 are spaced apart and connected to the second scan line 122b. The second source 1262 is connected to the data line 121. The conductor layer 1266 is arranged in a same layer as the second source 1262 and the second metal layer 124, and the conductor layer 1266 is disposed between and spaced apart from the second source 1262 and the second metal layer 124. The second active layer 1263 is connected between the second source 1262 and the conductor layer 1266. The third active layer 1265 is connected between the conductor layer 1266 and the second metal layer 124. Orthographic projection of the second active layer 1263 on the second gate 1261 at least covers part of the second gate 1261. Orthographic projection of the third active layer 1265 on the third gate 1264 at least covers part of the third gate 1264. For example, the orthographic projection of the second active layer 1263 on the second gate 1261 may be located within the second gate 1261. The orthographic projection of the third active layer 1265 on the third gate 1264 may be located within the third gate 1264. A stacked structure between the second source 1262, the second active layer 1263, and the conductor layer 1266 forms a channel structure. A stacked structure between the conductor layer 1266, the third active layer 1265, and the second metal layer 124 forms a channel structure.

Refer to FIG. 12 and FIG. 13. The second TFT 126 (T2) is configured as a double-gate structure with two gates, namely, the second gate 1261 and the third gate 1264. Correspondingly, the second TFT 126 (T2) have two channel structures. When a current is transmitted in the second TFT 126 (T2), the current needs to pass the two channel structures. Because a channel structure has a large impedance, impedance formed by the two channel structures is greater, so that a transmission speed of the current is reduced, and current leakage of the second TFT 126 (T2) can be reduced.

Still refer to FIG. 9. The third TFT 127 connected between the second metal layer 124 and the scan line includes a fourth gate 1271, a second drain 1272, and a fourth active layer 1273. The fourth gate 1271 is connected to the second scan line 122b. The second drain 1272 and the second metal layer 124 are arranged in a same layer and spaced apart. The second drain 1272 is connected to the reflective electrode layer 130 through the via hole 1201. The fourth active layer 1273 is connected between the second metal layer 124 and the second drain 1272. Orthographic projection of the fourth active layer 1273 on the fourth gate 1271 at least covers part of the fourth gate 1271. For example, the orthographic projection of the fourth active layer 1273 on the fourth gate 1271 may be located within the fourth gate 1271. A channel structure of the third TFT 127 refers to a stacked structure between the second metal layer 124, the fourth active layer 1273, and the second drain 1272.

Refer to FIG. 9. When the first scan lines 122a are enabled, and the second scan lines 122b are disabled, the first gate 1251 generates an electrical signal. The electrical signal generated by the first gate 1251 may cause the first active layer 1254 to be conductive. The first active layer 1254 transmits the electrical signal generated by the first source 1252 to the first drain 1253. The first drain 1253 transmits the electrical signal to the reflective electrode layer 130 electrically connected to the first drain 1253.

Refer to FIG. 9. When the first scan lines 122a are disabled, and the second scan lines 122b are enabled, the second gate 1261 and the fourth gate 1271 generate an electrical signal. The electrical signal generated by the second gate 1261 causes the second active layer 1263 to be conductive, and the electrical signal generated by the fourth gate 1271 causes the fourth active layer 1273 to be conductive. The second active layer 1263 transmits the electrical signal generated by the second source 1262 to the second metal layer 124, and then transmits the electrical signal of the second metal layer 124 to the second drain 1272 through the fourth active layer 1273. The second drain 1272 transmits the electrical signal to the reflective electrode layer 130 electrically connected to the second drain 1272.

Refer to FIG. 12. When the first scan lines 122a are disabled, and the second scan lines 122b are enabled, the second gate 1261, the third gate 1264, and the fourth gate 1271 generates an electrical signal. The electrical signals generated by the second gate 1261, the third gate 1264, and the fourth gate 1271 respectively cause the second active layer 1263, the third active layer 1265, and the fourth active layer 1273 to be conductive. The second active layer 1263 transmits the electrical signal generated by the second source 1262 to the conductor layer 1266. The third active layer 1265 transmits the electrical signal of the conductor layer 1266 to the second metal layer 124. The fourth active layer 1273 transmits the electrical signal of the second metal layer 124 to the second drain 1272. The second drain 1272 transmits the electrical signal to the reflective electrode layer 130 electrically connected to the second drain 1272.

In addition, there are many lines such as the data lines 121, the first scan lines 122a, and the second scan lines 122b disposed in the TFT substrate 100. To prevent affecting the display effect of the display panel 10 due to voltage fluctuation caused by mutual interference between signals of the lines, with reference to FIG. 9 or FIG. 12, in this embodiment, a common voltage line 129 may also be disposed in the TFT substrate 100. The common voltage line 129, the first scan lines 122a, and the second scan lines 122b are arranged in parallel in a same layer. Exemplarily, the common voltage line 129 may be disposed between the first scan lines 122a and the second scan lines 122b.

In the description of embodiments of this application, it needs to be noted that: Unless otherwise specified or limited, terms "install", "communicate", and "connect" shall be understood in a broad sense, for example, may indicate a fixed connection, an indirect connection by using an intermediate medium, or internal communication between two elements or an interaction relationship between two elements. A person of ordinary skill in the art can understand specific meanings of the foregoing terms in embodiments of this application according to a specific situation.

The terms such as "first", "second", "third", and "fourth" (if any) in the specification and claims of the embodiments of this application and in the accompanying drawings are used for distinguishing between similar objects and not necessarily used for describing any particular order or sequence.

## Claims

1. An electrowetting substrate, comprising: a first base as well as a plurality of data lines, a plurality of first scan lines, a plurality of second scan lines, and a plurality of thin film transistors that are disposed on the first base, wherein
the first scan lines and the second scan lines are alternately arranged and perpendicularly intersect the data lines, pixels are defined by the data lines, the first scan lines, and the second scan lines, and each of the pixels is internally provided with the thin film transistors; and
further comprising: a first metal layer, a first dielectric layer, a second metal layer, a second dielectric layer, and a reflective electrode layer sequentially arranged above the first base, wherein the first metal layer, the first dielectric layer, and the second metal layer form a first storage capacitor, and the second metal layer, the second dielectric layer, and the reflective electrode layer form a second storage capacitor;
the thin film transistors comprise first thin film transistors, second thin film transistors, third thin film transistors, the first thin film transistors are connected to the first scan lines, and both the second thin film transistors and the thin film transistors are connected to the second scan lines; when the first scan lines are enabled and the second scan lines are disabled, the first storage capacitor and the second storage capacitor are connected in series; and when the first scan lines are disabled and the second scan lines are enabled, the first storage capacitor stores charge, and the second storage capacitor is short-circuited.

2. The electrowetting substrate according to claim 1, wherein the first thin film transistors are connected between the data lines and the first scan lines, and are electrically connected to the reflective electrode layer.

3. The electrowetting substrate according to claim 1, wherein the second thin film transistors are connected between the data lines and the second scan lines, and are electrically connected to the second metal layer; and
the third thin film transistors are connected between the second metal layer and the second scan lines, and are electrically connected to the reflective electrode layer.

4. The electrowetting substrate according to any one of claims 1 to 3, wherein the reflective electrode layer covers the first thin film transistors, the second thin film transistors, and the third thin film transistors.

5. The electrowetting substrate according to claim 4, wherein the reflective electrode layer covers entire regions of pixel openings of the pixels.

6. The electrowetting substrate according to any one of claims 1 to 5, wherein the data lines are disposed on a side that is of the first scan lines and the second scan lines and that is away from the first base, and the second metal layer and the data lines are arranged in a same layer.

7. The electrowetting substrate according to any one of claims 1 to 6, wherein the first scan lines, the second scan lines, and the first metal layer are arranged in a same layer.

8. The electrowetting substrate according to any one of claims 1 to 7, wherein a third dielectric layer is further provided between the second metal layer and the second dielectric layer.

9. The electrowetting substrate according to any one of claims 1 to 8, wherein the first thin film transistor comprises a first gate, a first source, a first drain, and a first active layer,
the first gate is connected to the first scan line, the first source is connected to the data line, the first drain and the first source are arranged in a same layer and spaced apart, the first drain is electrically connected to the reflective electrode layer, the first active layer is connected between the first source and the first drain, and orthographic projection of the first active layer on the first gate at least covers part of the first gate.

10. The electrowetting substrate according to any one of claims 1 to 9, wherein the second thin film transistor comprises a second gate, a second source, and a second active layer; and
the second gate is connected to the second scan line, the second source is connected to the data line, the second active layer is connected between the second source and the second metal layer, and orthographic projection of the second active layer on the second gate at least covers part of the second gate.

11. The electrowetting substrate according to any one of claims 1 to 9, wherein the second thin film transistor comprises a second gate, a third gate, a second source, a second active layer, a third active layer, and a conductor layer; and
the second gate and the third gate are spaced apart and connected to the second scan line, the second source is connected to the data line, the conductor layer is disposed between and spaced apart from the second source and the second metal layer, the second active layer is connected between the second source and the conductor layer, the third active layer is connected between the conductor layer and the second metal layer, orthographic projection of the second active layer on the second gate at least covers part of the second gate, and orthographic projection of the third active layer on the third gate at least covers part of the third gate.

12. The electrowetting substrate according to any one of claims 1 to 11, wherein the third thin film transistor comprises a fourth gate, a second drain, and a fourth active layer; and
the fourth gate is connected to the second scan line, the second drain and the second metal layer are arranged in a same layer and spaced apart, the second drain is electrically connected to the reflective electrode layer, the fourth active layer is connected between the second metal layer and the second drain, and orthographic projection of the fourth active layer on the fourth gate at least covers part of the fourth gate.

13. An electrowetting display panel, comprising an opposing substrate, at least one electrowetting layer, and the electrowetting substrate according to any one of claims 1 to 12, wherein
the opposing substrate is cell-assembled with the electrowetting substrate, and the electrowetting layer is encapsulated between the electrowetting substrate and the opposing substrate.

14. The electrowetting display panel according to claim 13, wherein the electrowetting layer comprises a bottom electrowetting layer formed on a surface of the reflective electrode layer of the electrowetting substrate, the bottom electrowetting layer comprises a transparent hydrophobic layer and a plurality of electrowetting units, and the plurality of electrowetting units are arranged on the transparent hydrophobic layer in an array.

15. The electrowetting display panel according to claim 14, wherein the electrowetting units are sandwiched between the transparent hydrophobic layer and the opposing substrate.

16. The electrowetting display panel according to claim 14, wherein the electrowetting layer further comprises at least one superposed electrowetting layer stacked on a side that is of the bottom electrowetting layer and that is away from the reflective electrode layer;
the superposed electrowetting layer comprises a transparent electrode layer, a transparent hydrophobic layer, and a plurality of electrowetting units; and in the superposed electrowetting layer, the transparent hydrophobic layer is stacked on the transparent electrode layer, and the plurality of electrowetting units are arranged on the transparent hydrophobic layer in an array.

17. The electrowetting display panel according to claim 16, wherein retaining walls are disposed between the transparent hydrophobic layer and the opposing substrate/the transparent electrode layer, the transparent hydrophobic layer, the retaining walls, and the opposing substrate/the transparent electrode layer define the electrowetting units, and the electrowetting units are filled with polar liquid and non-polar liquid that are immiscible.

18. The electrowetting display panel according to claim 13 to 17, wherein the opposing substrate comprises a second base and a common electrode layer, and the common electrode layer is located on a side that is of the second base and that faces the electrowetting substrate.

19. An electrowetting display apparatus, comprising the electrowetting display panel according to any one of claims 13 to 18.
